(19)

**Europäisches Patentamt**
**European Patent Office**
**Office européen des brevets**

(11) **EP 4 753 403 A1**

(12) **EUROPEAN PATENT APPLICATION**

(43) Date of publication:
03.06.2026  Bulletin 2026/23

(21) Application number: 24215646.1

(22) Date of filing: 27.11.2024

(51) International Patent Classification (IPC):
*H10D 84/01* (2026.01)   *H10D 30/01* (2025.01)
*H10D 64/27* (2025.01)   *H10D 84/03* (2025.01)
*H10D 84/83* (2025.01)

(52) Cooperative Patent Classification (CPC):
H10D 84/8311; H10D 30/0193; H10D 64/516;
H10D 84/0128; H10D 84/0144; H10D 84/038;
H10D 84/8314; H10D 84/832; H10D 30/0195

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Imec VZW**
**3001 Leuven (BE)**

(72) Inventors:
• **VELOSO, Anabela**
**3001 Leuven (BE)**
• **ZHOU, Xiuju**
**3001 Heverlee (BE)**

(74) Representative: **AWA Sweden AB**
**Matrosgatan 1**
**Box 5117**
**200 71 Malmö (SE)**

(54) **METHOD FOR FABRICATING A SEMICONDUCTOR STRUCTURE**

(57)     According to an aspect of the present inventive concept there is provided a method (1000) for fabricating a semiconductor structure (100), the method comprising: providing (1100) a substrate (110); providing (1200), on top of the substrate (110), a multi-layer stack (200) comprising, sacrificial layers (211, 212, 213, 214, 215) of a first type, sacrificial layers (221, 222, 223) of a second type, and first, second, and third channel layers (201, 202, 203); forming (1300) a first and second ridge (130, 140) from the multi-layer stack (200); and for the first ridge (130): removing (1400) the sacrificial layers (221, 222, 223) of the second type by selective etching, oxidizing (1500) the sacrificial layers (211, 212, 213, 214, 215) of the first type, and removing (1600) the second channel layer (202) by selective etching, wherein the oxidized sacrificial layers (131, 133, 135, 137, 139) protect the substrate (110) and the first and third channel layers (201, 203) from the selective etching step used to remove the second channel layer (202).

```
1000
┌──────────────────────────────────────────┐
│           Providing a substrate            │─── 1100
└──────────────────────────────────────────┘
┌──────────────────────────────────────────┐
│ Providing, on top of the substrate, a      │
│ multilayer stack comprising:               │
│ a first sacrificial layer of a first type  │
│ on the substrate,                          │
│ a first sacrificial layer of a second type │
│ on the first sacrificial layer of the      │
│ first type,                                │
│ a second sacrificial layer of the first    │
│ type on the first sacrificial layer of the │
│ second type,                               │
│ a first channel layer on the second        │
│ sacrificial layer of the first type,       │
│ a third sacrificial layer of the first type│
│ on the first channel layer,                │
│ a second sacrificial layer of the second   │
│ type on the third sacrificial layer of the │
│ first type,                                │
│ a second channel layer on the second       │
│ sacrificial layer of the second type,      │
│ a third sacrificial layer of the second    │───1200
│ type on the second channel layer,          │
│ a fourth sacrificial layer of the first    │
│ type on the third sacrificial layer of the │
│ second type,                               │
│ a third channel layer on the fourth        │
│ sacrificial layer of the first type,       │
│ a fifth sacrificial layer of the first     │
│ type on the third channel layer, and       │
│ a fourth sacrificial layer of the second   │
│ type on the fifth sacrificial layer of the │
│ first type,                                │
└──────────────────────────────────────────┘
┌──────────────────────────────────────────┐
│ Forming a first and second ridge from the  │─── 1300
│ multilayer stack                           │
└──────────────────────────────────────────┘
┌──────────────────────────────────────────┐
│ Removing, for the first ridge, the         │─── 1400
│ sacrificial layers of the second type by   │
│ selective etching                          │
└──────────────────────────────────────────┘
┌──────────────────────────────────────────┐
│ Oxidizing, for the first ridge, the        │─── 1500
│ sacrificial layers of the first type       │
└──────────────────────────────────────────┘
┌──────────────────────────────────────────┐
│ Removing, for the first ridge, the second  │─── 1600
│ channel layer by selective etching         │
└──────────────────────────────────────────┘
```

*Figure 1*

EP 4 753 403 A1

## Description

Technical field

The present inventive concept relates to the field of semiconductor device fabrication, specifically to methods for integrating nanosheet field-effect transistors (NSFETs) with different gate dielectric thicknesses and varied vertical spacing between stacked nanosheets on a single semiconductor chip.

Background

Nanosheet (NS) field-effect transistors (NSFETs) typically consist of several vertically stacked nanosheets per structure in order to obtain devices with higher effective width at a reduced footprint on the wafer and hence enabling higher device performance.

NSFETs may be used as logic transistors and/or Input/Output (I/O) transistors. The logic transistors and/or I/O transistors may be co-integrated on the same substrate and form an electrical circuit. The logic transistors execute instructions and/or process data and/or perform logical operations. The logic transistors may alternatively be called core transistors or primary transistors. The I/O transistors manage input and output signals to and from the electrical circuit.

Summary

It is an objective of the present inventive concept to facilitate co-integration of transistors of different types. In particular, it is an objective of the present inventive concept to facilitate co-integration of transistors having different vertical separation distances between their stacked channel layers. In particular, it is an objective to facilitate co-integration of transistors with differing current flows (or facilitate co-integration of semiconductor structures that can be used to manufacture co-integrated transistors with differing current flows). In particular, it is an objective to facilitate co-integration of an I/O transistor and a logic transistor on a same substrate. It is a realization that an I/O transistor has different electrical specifications then the various variants of logic transistors, and that it typically needs to withstand higher supply voltages and larger currents.

It is an objective to facilitate high-quality co-integrated transistors. In particular, it is an objective to facilitate co-integrated transistors with lower/minimized parasitic capacitance and/or lower/minimized leakage current.

It is an objective to facilitate efficient production of co-integrated transistors. In particular, it is an objective to facilitate cost-efficient production of co-integrated transistors and/or facilitate a lean production of co-integrated transistors (e.g., facilitate production requiring fewer extra process steps).

In the following, relative spatial terms such as "top", "bottom", "lower", "vertical", "stacked on top of", are to be understood as denoting locations or directions within a frame of reference of the co-integrated semiconductor structure. In particular, the terms may be understood in relation to a normal direction to a substrate on which stacks of layers are formed. Correspondingly, terms such as "lateral" and "horizontal" are to be understood as locations or directions parallel to the substrate.

According to an aspect of the present inventive concept there is provided a method for fabricating a semiconductor structure, the method comprising:

providing a substrate,
providing, on top of the substrate, a multi-layer stack comprising:

a bottom sacrificial layer comprising:
a first sacrificial layer of a first type on the substrate and a first sacrificial layer of a second type on the first sacrificial layer of the first type; or a first sacrificial layer of a second type on the substrate,
a second sacrificial layer of the first type on the bottom sacrificial layer,
a first channel layer on the second sacrificial layer of the first type,
a third sacrificial layer of the first type on the first channel layer,
a second sacrificial layer of the second type on the third sacrificial layer of the first type,
a second channel layer on the second sacrificial layer of the second type,
a third sacrificial layer of the second type on the second channel layer,
a fourth sacrificial layer of the first type on the third sacrificial layer of the second type,
a third channel layer on the fourth sacrificial layer of the first type,

a fifth sacrificial layer of the first type on the third channel layer, forming a first and second ridge from the multi-layer stack; and
for the first ridge:

removing the sacrificial layers of the second type by selective etching, oxidizing the sacrificial layers of the first type, and
removing the second channel layer by selective etching,
wherein the oxidized sacrificial layers protect the substrate and the first and third channel layers from the selective etching step used to remove the second channel layer.

Additionally, the multi-layer stack may comprise a fourth sacrificial layer of the second type on the fifth sacrificial layer of the first type.

Thus, the first sacrificial layer of the first type and the fourth sacrificial layer of the second type may be optional. The first sacrificial layer of the first type may, when oxidized, protect the substrate. This may be useful in case of a Si substrate or group IV substrate.

Notably, the second sacrificial layer of the first type on the bottom sacrificial layer would correspond to a first sacrificial layer of a first type on the bottom sacrificial layer if the latter consists only of a first sacrificial layer of a second type on the substrate.

In the following text, an example of the method is given wherein the multi-layer stack comprises the first sacrificial layer of the first type and the fourth sacrificial layer of the second type. However, it should be understood that the method may be performed using a multi-layer stack which lacks the first sacrificial layer of the first type and/or the fourth sacrificial layer of the second type.

According to this example there is provided a method for fabricating a semiconductor structure, the method comprising:

   providing a substrate,
   providing, on top of the substrate, a multi-layer stack comprising:

      a first sacrificial layer of a first type on the substrate,
      a first sacrificial layer of a second type on the first sacrificial layer of the first type,
      a second sacrificial layer of the first type on the first sacrificial layer of the second type,
      a first channel layer on the second sacrificial layer of the first type,
      a third sacrificial layer of the first type on the first channel layer,
      a second sacrificial layer of the second type on the third sacrificial layer of the first type,
      a second channel layer on the second sacrificial layer of the second type,
      a third sacrificial layer of the second type on the second channel layer,
      a fourth sacrificial layer of the first type on the third sacrificial layer of the second type,
      a third channel layer on the fourth sacrificial layer of the first type,
      a fifth sacrificial layer of the first type on the third channel layer, and
      a fourth sacrificial layer of the second type on the fifth sacrificial layer of the first type,

   forming a first and second ridge from the multi-layer stack, and for the first ridge:

      removing the sacrificial layers of the second type by selective etching,
      oxidizing the sacrificial layers of the first type, and
      removing the second channel layer by selective etching,

wherein the oxidized sacrificial layers of the first type protect the substrate and the first and third channel layers from the selective etching step used to remove the second channel layer.

Hereby, there is provided an improved method enabling different types of devices to be formed on a single substrate.

The first and second ridge may be used for producing a first and a second transistor, respectively. The first and second transistors may be NSFETs. The channel layers may form the nanosheets of said NSFETs.

As mentioned, for the first ridge, the second channel layer is removed. Accordingly, the second transistor may comprise the first, second and third channel layers while the first transistor lacks the second channel layer. Accordingly, the vertical separation between the neighboring channel layers of the first ridge may be larger than the separation between neighboring channel layers of the second ridge.

The removing of the second channel layer by selective etching may correspond to removing the channel layer that is not sandwiched by oxidized sacrificial layers. Hence, the step of removing the second channel layer (i.e., the channel layer non-sandwiched by oxidized sacrificial layers) may be applied multiple times for structures with more than one channel layer that is not sandwiched by oxidized sacrificial layers, e.g., in cases where a higher number of stacked NS is intended for final devices, i.e., when there are more than three stacked NS per stack.

It is appreciated that the first sacrificial layer may not be necessary in certain scenarios. For instance, in the case of silicon-on-insulator (SOI) wafers, or for devices designed to incorporate a dielectric isolation layer beneath them, the first sacrificial layer may be omitted.

It is a realization that the larger vertical distance between the channel layers of the first ridge makes the first ridge suitable for forming a transistor that requires a thicker gate dielectric to be able to withstand higher voltages and currents, e.g. suitable for forming an I/O transistor. Extra vertical space between the channel layers provides extra room for other transistor parts, e.g., extra room for gate dielectric material. For example, extra room may be provided for a thicker gate dielectric. Such thicker gate dielectric material may be required for the device to be able to withstand higher supply voltages and also facilitate lower leakage currents.

It is a realization that the smaller vertical channel layers separation of the second ridge makes the second ridge suitable for forming a transistor intended to withstand lower supply voltages and hence to carry smaller currents, e.g., suitable for forming a logic transistor. The smaller vertical channel layers separation may also minimize parasitic effects thus enhancing overall device efficiency.

In other words, the method facilitates fabricating both NSFETs for logic (thin-gate dielectrics) and NSFETs for I/O (thick-gate dielectrics) on the same substrate or wafer. In yet other words, the method enables fabrication of both devices with either thin or thick gate dielectrics, and the method enables meeting requirements of different types of devices from, e.g., logic and/or I/O devices, respectively.

Hence, devices with different vertical spacing between stacked NS and with varying number of NS per structure can be obtained on the same substrate in a simplified way, i.e., different types of NS devices may be provided on the same substate.

For simplicity, it is herein described a case where a starting structure consists of three stacked NS channels for logic devices, and resulting two stacked NS channels for I/O devices. However, it is to be understood that the method may be extended to include a larger number of stacked NS per structure.

The devices may have the same processing until Replacement Metal Gate (RMG) module and may also have the same processing for RMG metal-fill, CMP, and/or subsequent steps. In particular, the method further allows for uniform processing of all devices up until the RMG module and, optionally, after the RMG module. This means that the same fabrication steps may be applied consistently across all devices.

The vertically stacked NS structures may, e.g., be formed by epitaxial growth at an early stage in the flow to allow obtaining different vertical distances between the stacked NS at the RMG module. This may be enabled by using different selectivity removal behaviors of different types of sacrificial layers (e.g., different Ge% used in different types of sacrificial layers comprising $Si_xGe_y$ and/or different oxidation kinetics of $Si_xGe_y$ compared to Si).

The substrate may be a bulk silicon (Si) substrate, a group IV substrate, or a silicon-on-insulator (SOI) substrate. SOI substrates may for example consist of a thin layer of silicon separated from the bulk substrate by an insulating layer, typically a silicon dioxide (i.e., a buried oxide, BOX, layer).

The term "ridge" may refer to a structural element or device. The ridge may alternatively be referred to as a fin. The ridge (fin) may comprise layers of the entire multi-layer stack. For example, the fin may comprise the first sacrificial layer of a first type and all layers up to the fourth sacrificial layer of the second type in case of three stacked NS per starting structure. The ridges may, e.g., denote raised portions in a semiconductor device where gate stacks are formed. For instance, a single fin (ridge) may be used to produce a NSFET.

The first ridge may be used to produce a first transistor, which could be an I/O transistor. On the other hand, the second ridge may be used to produce a second transistor, such as a logic transistor, which might require different specifications, such as a thicker gate dielectric to be able to withstand higher voltages being required for the I/O device.

It is to be understood that any suitable number of ridges or transistors may be formed on the substrate, e.g., by processing the ridges in parallel or repeating or scaling the method.

The first, second, third, fourth, and fifth sacrificial layers of the first type are made of a same material or comprise a same material. Similarly, the first, second, third, and fourth sacrificial layers of the second type are made of a same material or comprise a same material. Hence, each type of sacrificial layer maintains uniform material properties within its group, while allowing for different material characteristics between the first and second types. The first and second types of sacrificial layers may, for example, comprise different silicon-germanium (SiGe) compositions. This means that the specific ratio of silicon to germanium in the two types of layers can be varied, e.g., to achieve the desired etch rate differences.

It is appreciated that the step of oxidizing the sacrificial layers of the first type is performed subsequent to the step of removing the sacrificial layers of the second type.

Further, the step of removing the second channel layer may comprise removing an uncovered channel within the device formed by the first ridge. The removal of the second channel layer may, e.g., be achieved through wet etching and/or dry/plasma etching.

Selective etching may refer to a process where different materials are etched at different rates. In this context, the sacrificial layers of the first type may have a significantly lower etch rate compared to the sacrificial layers of the second type. Hence, when an etching process is applied, the material of the first type will be removed substantially more slowly than the material of the second type. The differential etching rate allows for more controlled removal of specific layers.

The sacrificial layers of the first type surround the channel layers in the multi-layer stack that are not to be removed from the device structure. In other words, the sacrificial layers of the first type may act as sacrificial cap layers.

It is appreciated that the method enables any thickness of the channels to be used.

The method may further comprise protecting the second ridge during the steps of, for the first ridge: removing the sacrificial layers of the second type, oxidizing the sacrificial layers of the first type, and removing the second (i.e., middle) channel layer.

In other words, the second ridge may be covered during said steps, e.g., by a photoresist, a spin-on-carbon (SOC) layer, or/and a protective dielectric layer. Photoresist is a light-sensitive material which may be used to form a coating on a surface. On the other hand, a protective SOC or a dielectric layer, such as silicon dioxide, can shield the second ridge from certain processing steps.

The protecting of the second ridge may ensure that the second ridge remains unaffected by etching or other fabrication processes performed on the first ridge.

As mentioned, the first and second ridge may be used to produce transistors. Accordingly, a gate stack for the channel layers of the first ridge may be formed. Similarly, a gate stack for the channel layers of the second ridge may be formed. The term "gate stack" refers to a layered structure that may control a flow of current in the final device. The gate stack surrounding each channel layer may vertically extend in a space formed by removing a sacrificial layer, e.g. in a space formed by removing sacrificial layers of the second type and/or sacrificial layers of the first type.

As earlier mentioned, the method comprises removing sacrificial layers of the second type from the first ridge. Similarly, sacrificial layers of the second type may be removed from the second ridge, though not at the same time. Sacrificial layers of both the first and second ridge may be removed before forming the gate stacks of the first and second ridge.

The gate stack around the channel layers of the first ridge and the gate stack around the channel layers of the second ridge may be formed simultaneously or separately. For example, the gate dielectric layer or layers of the gate stack around the channel layers of the first ridge and the gate dielectric layer or layers of the gate stack around the channel layers of the second ridge may be formed separately, to facilitate different thicknesses.

As described above, a gate stack for the channel layers is formed around the channel layers. Each gate stack may comprise a gate dielectric layer(s) followed by a gate metal(s) conformally surrounding the channel layers. The gate metal may be a work function metal (WFM). Each gate stack may be arranged in a gate all around (GAA) configuration around the channel layers of the respective ridge, i.e., fully surrounding each of the stacked channel layers. It can also be arranged in a forksheet type of configuration wherein a dielectric wall neighbors one sidewall of the stacked NS channels.

In the following, a gate stack for the channel layers of the first ridge will be discussed.

Accordingly, the method may further comprise forming a gate stack on the first ridge, the gate stack of the first ridge extending around the first and third channel layers of the first ridge and at least partially extending in a space formed by removing the second channel layer of the first ridge, the gate stack of the first ridge may comprise a gate dielectric and a gate metal(s).

As earlier mentioned, by removing the second channel layer, the method facilitates using the space formed for other purposes. In particular, the space formed may be used for forming a thicker gate stack. Accordingly, the method may comprise forming a gate stack of the first ridge, the gate stack of the first ridge extending around the first and third channel layers of the first ridge and at least partially extending in a space formed by removing the second channel layer of the first ridge.

As described below, the oxidized sacrificial layers may be removed before forming the gate stack. Alternatively, the oxidized sacrificial layers may remain and form part of the gate dielectric.

In the following, a gate stack for the channel layers of the second ridge will be discussed.

The method may further comprise: removing, by selective etching, the sacrificial layers of the first and second types from the second ridge, forming a gate stack on the second ridge, the gate stack of the second ridge extending around the first, second, and third channel layers of the second ridge, the gate stack of the second ridge comprising a (thinner) gate dielectric and a gate metal (than in the first ridge).

In other words, the method may comprise selectively etching away the sacrificial layers of both the first and second types from the second ridge. After this etching process, a gate stack may be formed on the second ridge. This gate stack may, respectively, wrap around the first, second, and third channel layers of the second ridge, and it may consist of a thinner gate dielectric and possible also thinner gate metal(s) than those in the first ridge.

The first ridge may be protected during the step of removing the sacrificial layers of the first and second types from the second ridge.

In other words, during the process of removing the sacrificial layers of the first and second types from the second ridge, the first ridge may be temporarily covered or shielded to prevent it from being affected by the etching process. The protection may be achieved using materials such as photoresist, a spin-on-carbon layer, or/and a protective dielectric layer, which may act as barriers to safeguard the first ridge.

By protecting the first ridge during the etching processes applied to the second ridge, the first ridge remains intact and unaffected, thereby maintaining its structural and functional integrity. This allows for more precise and controlled fabrication of both the first and the second ridges.

The first ridge and the second ridge may form respective devices co-integrated on the substrate. In other words, the first ridge may be co-integrated with the second ridge, or vice versa. Hence, the first and second ridge may each form part of separate devices that are integrated together on the same base material (i.e., substrate/wafer). This means that the first and second ridges are designed to coexist on a single substrate, allowing for a more compact and efficient design. The term "co-integrated" implies that these devices are not just placed next to each other but may be functionally and structurally interconnected.

Accordingly, devices with different vertical channel layers spacing, e.g., to be used for different purposes such as logic vs I/O purposes, may be integrated on the same substrate.

In addition to forming a gate stack, the method may comprise forming source/drain regions at opposite ends of the ridge. Thus, a transistor may be formed.

The gate dielectric of the gate stack of the first ridge may be thicker than the gate dielectric of the gate stack of the second ridge.

In other words, the insulating layer or layers (gate dielectric) in the gate structure (gate stack) of the first ridge can be made thicker compared to the insulating layer or layers in the gate structure of the second ridge. This variation in the gate dielectric thickness, as allowed by the variation in the vertical distance between the stacked channel layers for a given ridge or ridges, may be adjusted based on the specific technology node and the specifications of the devices being targeted.

The method in particular facilitates forming a gate with a thicker gate dielectric. A thicker gate dielectric is advantageous and required for transistors which may need to operate at higher voltages, as is the case for I/O devices.

Hence, by the gate dielectric of the first ridge being thicker, performance and leakage requirements of various devices, including logic and I/O devices, may be met. Therefore, the method enables the creation of devices that can operate efficiently under different conditions and specifications. Additionally, this method allows for greater adaptability in fabrication, ensuring that devices can be tailored to meet specific performance targets without compromising on quality or efficiency.

The forming of the gate dielectric of the gate stack of the first ridge may comprise replacing the oxidized sacrificial layers of the first type by a dielectric such as an oxide layer.

In other words, removal of the uncovered oxidized sacrificial layers of the first type, selectively to the channels, may be followed by a (e.g., thick) dielectric (such as oxide) deposition or growth. The growth of the dielectric may, e.g., start only from the first and third channel layers of the first ridge (e.g., from the exposed Si channel surfaces in case of Si channels).

Hence, the oxidized sacrificial layers may be replaced by a fresh or new dielectric (such as oxide) and/or with a dielectric with a desired thickness and electrical properties, e.g., with a thicker dielectric layer or layers used for forming an I/O device than that used for forming a logic device.

The forming of the gate dielectric may further comprise forming a high-k dielectric. That is, the gate dielectric may, e.g., comprise an oxide and a high-k gate dielectric.

The channel layers may comprise $Si_{1-a}Ge_a$, the sacrificial layers of the first type may comprise $Si_{1-b}Ge_b$, and/or the sacrificial layers of the second type may comprise $Si_{1-c}Ge_c$, wherein $0 \le a < b < c$.

In other words, the channel layers in the semiconductor structure may be made from a silicon-germanium alloy ($Si_{1-a}Ge_a$), where the proportion of germanium (Ge) is represented by 'a'. Additionally, the sacrificial layers can also be made from silicon-germanium alloys with different proportions of germanium. The first type of sacrificial layer may have a germanium proportion represented by 'b' ($Si_{1-b}Ge_b$), and the second type may have a proportion represented by 'c' ($Si_{1-c}Ge_c$). The values of 'a', 'b', and 'c' are such that 0 is less than or equal to 'a', which is less than 'b', which is less than 'c'. This means that the germanium content increases progressively from the channel layers to the second type of sacrificial layers.

Hence, by providing different germanium content in the channel layers and the different types of sacrificial layers, the fabrication process of the semiconductor structure can be well controlled. It explores differences in material properties, e.g., coupled to the different etching and/or oxidation behaviors of the different $Si_xGe_y$ materials. In particular, using different germanium concentrations in the different types of sacrificial layers can improve the etching selectivity between them, e.g., leading to a more controllable and efficient manufacturing process. For the channel layers, the Ge content (if any) may also, e.g., affect electrical performance, leakage currents, strain engineering, and/or bandgap tuning of the semiconductor structure.

For example, $0 \le a < 0.1$, $0.15 < b < 0.35$, and/or $0.4 \le c < 1$. Further, for a=0, $b \le 0.25$ may be suitable.

In other words, for the channel layers, the germanium proportion 'a' may range from 0 to less than 0.1. For the first type of sacrificial layer, the germanium proportion 'b' may range from greater than 0.15 to less than 0.35. For the second type of sacrificial layer, the germanium proportion 'c' may range from 0.4 to less than 1. Additionally, when the germanium proportion 'a' is 0, the germanium proportion 'b' in the first type of sacrificial layer may, e.g., be up to 0.25.

In an example, a=0, b=0.25, and c=0.45 or 0.55, may be used.

The above ranges may allow for desired and precise control over the characteristics of the different layers of the multi-layer stack, based on the varying layer material compositions. Hereby, the material properties of the different layers may be fine-tuned to meet specific or desired characteristics, such as the reaction or degrees of reaction to etching and/or annealing/oxidation processes.

A temperature during the step of oxidizing may be below or at 450 degrees Celsius. In other words, the temperature during the step of oxidizing may be up to 450 degrees Celsius. This means that the oxidation process may be conducted at relatively low temperatures. Thereby, thermal damage to the structure, including layers intermixing or elements diffusion, may be avoided or reduced.

The step of oxidizing may comprise a steam anneal.

The step of oxidizing may be performed by any, or different, thermal anneals, e.g. any low thermal budget anneal. Advantageously, the step of oxidizing may be performed by steam anneal. An oxidation rate of steam anneal may be different for channel layers and sacrificial layers. This may facilitate oxidizing the sacrificial layers of the first type while leaving the channel layers un-oxidized. For example steam anneal may have a greater (e.g., substantially greater) oxidation rate for SiGe than for Si, and/or also exhibit a dependence on the Ge percentage of the SiGe layers.

In particular, a single low thermal budget anneal (e.g., a single steam anneal step) may be used to transform the sacrificial layers of the first type into oxide layers, e.g., without significant channels (e.g., Si channels) oxidation, i.e., material dependent-oxidation kinetics. For example, various group IV materials may have different oxidation kinetics. By providing first and second types of sacrificial layers of different (e.g., $Si_xGe_y$) compositions with distinct etch selectivities (and also different oxidation kinetic behaviors), the etching processes can be optimized to achieve precise control over the removal of specific sacrificial layers. Furthermore, the channels in the multi-layer stack are not significantly impacted by the oxidation (anneal), in other words, the channel layers are not oxidized or only insignificantly oxidized.

Generally, the anneal may not significantly oxidize the channels, e.g.,Si channels. Also, there may be no intentional targeting of germanium (Ge) diffusion into the channels or the substrate (e.g. , Si). In other words, the movement of Ge atoms into the Si (or Si rich) layers may be avoided or minimized.

Hence, the integrity of the channels is not compromised, and the integrity of inner spacers is also further preserved. In particular, Ge diffusion is not relied upon, and without Ge diffusion, no Ge diffusion towards the inner spacers is enabled, thus preserving the integrity of the inner spacers in terms of electrical properties such as its k-value and its reliability behavior.

According to another aspect of the present inventive concept there is provided a device comprising a first and second ridge arranged on a substrate, each of the first and second ridge comprising a multi-layer stack comprising:

> a bottom sacrificial layer comprising:
>
>> a first sacrificial layer of a first type on the substrate and a first sacrificial layer of a second type on the first sacrificial layer of the first type; or a first sacrificial layer of a second type on the substrate,
>
> a second sacrificial layer of the first type on the bottom sacrificial layer
> a first channel layer on the second sacrificial layer of the first type,
> a third sacrificial layer of the first type on the first channel layer,
> a second sacrificial layer of the second type on the third sacrificial layer of the first type,
> a second channel layer on the second sacrificial layer of the second type,
> a third sacrificial layer of the second type on the second channel layer,
> a fourth sacrificial layer of the first type on the third sacrificial layer of the second type,
a third channel layer on the fourth sacrificial layer of the first type, and
a fifth sacrificial layer of the first type on the third channel layer,
wherein the channel layers comprises $Si_{1-a}Ge_a$, the sacrificial layers of the first type comprises $Si_{1-b}Ge_b$, and the sacrificial layers of the second type comprises $Si_{1-c}Ge_c$, and wherein $0 \leq a < b < c$.

Additionally, the multi-layer stack may comprise a fourth sacrificial layer of the second type on the fifth sacrificial layer of the first type.

Notably, the second sacrificial layer of the first type on the bottom sacrificial layer would correspond to a first sacrificial layer of a first type on the bottom sacrificial layer if the latter consists only of a first sacrificial layer of a second type on the substrate.

This aspect may generally present the same or corresponding advantages as the former aspect.

The device may be processed into co-integrated transistor. For example, the first and second ridge may be processed as described in the method of the former aspect.

Hence, there may (on a single substate) be provided co-integrated devices as fabricated in accordance with the former aspect.

In an example, $0 \leq a < 0.1$, $0.15 < b < 0.35$, and/or $0.4 \leq c < 1$.

Generally, all terms used in the claims are to be interpreted according to their ordinary meaning in the technical field, unless explicitly defined otherwise herein. All references to "a/an/the [element, device, component, etc.]" are to be interpreted openly as referring to at least one instance of said element, device, component, step, etc., unless explicitly stated otherwise.

Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.

> Figure 1 is a flowchart of a method for fabricating a semiconductor structure.
> Figures 2A-L schematically illustrate steps of a method for fabricating a semiconductor structure with the co-integration of different types of devices on a same substrate.

Detailed description

In cooperation with attached drawings, the technical contents and detailed description of the present invention are described thereinafter according to preferable embodiments, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

In the following figures, axes X, Y and Z indicate a first direction, a second direction transverse to the first direction, and a vertical or bottom-up direction, respectively. The X- and Y-direction may in particular be referred to as lateral or horizontal directions in that they are parallel to a main plane of a substrate. The Z-direction is parallel to a normal direction to the substrate.

In accordance with the above, the first direction (X-direction) may be understood as a direction in which the current of the finished transistors flow. The second direction (Y-direction) may be understood as a direction transverse to the first direction. The third direction (Z-direction) may be understood as the vertical or bottom-up direction. The first and second directions may be parallel to the substrate. The third direction may be normal to the substrate.

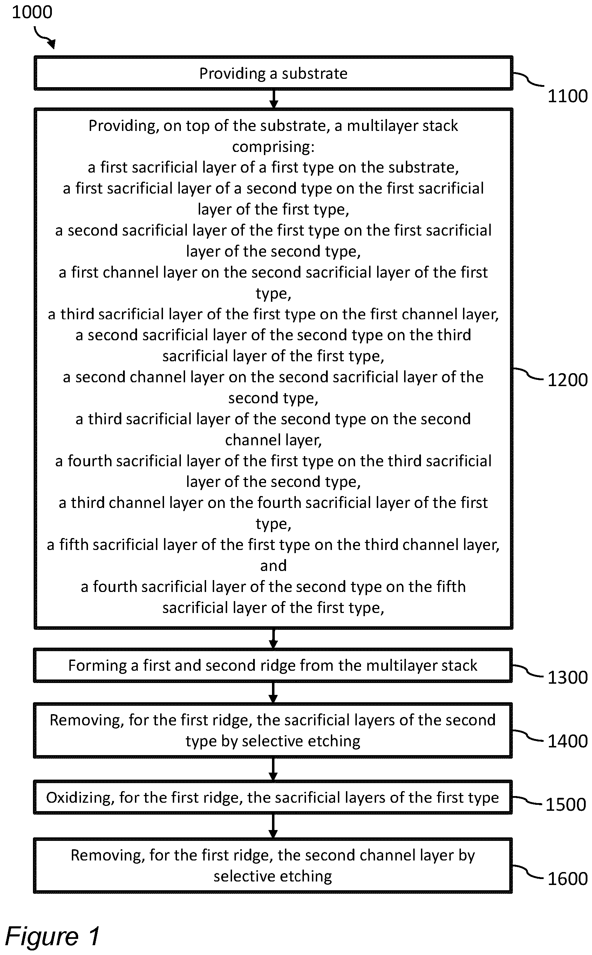

Figure 1 shows a flowchart of a method 1000 for fabricating a semiconductor structure 100.

In Figure 1, the method 1000 comprises the steps of:

> providing 1100 a substrate 110;
> providing 1200, on top of the substrate 110, a multilayer stack 200 comprising a first sacrificial layer 211 of a first type on the substrate 110, a first sacrificial layer 221 of a second type on the first sacrificial layer 211 of the first type, a second sacrificial layer 212 of the first type on the first sacrificial layer 221 of the second type, a first channel layer 201 on the second sacrificial layer 212 of the first type, a third sacrificial layer 213 of the first type on the first channel layer 201, a second sacrificial layer 222 of the second type on the third sacrificial layer 213 of the first type, a second channel layer 202 on the second sacrificial layer 222 of the second type, a third sacrificial layer 223 of the second type on the second channel layer 202, a fourth sacrificial layer 214 of the first type on the third sacrificial layer 223 of the second type, a third channel layer 203 on the fourth sacrificial layer 214 of the first type, a fifth sacrificial layer 215 of the first type on the third channel layer 203, and a fourth sacrificial layer 224 of the second type on the fifth sacrificial layer 215 of the first type;
> forming 1300 a first and second ridge 130, 140, (respectively), from the multi-layer stack 200;
> removing 1400, for the first ridge 130, the sacrificial layers 221, 222, 223, 224 of the second type by selective etching (with regard to the other layers in the structure);
> oxidizing 1500, for the first ridge 130, the sacrificial layers 211, 212, 213, 214, 215 of the first type; and removing 1600, for the first ridge 130, the second channel layer 202 by selective etching (to the other layers present in the structure).

It is appreciated that the oxidized sacrificial layers 211, 212, 213, 214, 215 of the first type protect the substrate 110 and the first and third channel layers 201, 203 from the etching.

Although not explicitly shown in Figure 1, the method 1000 may further comprise protecting the second ridge 140 during the steps of, for the first ridge 130: removing 1400 the sacrificial layers 221, 222, 223, 224 of the second type, oxidizing 1500 the sacrificial layers 211, 212, 213, 214, 215 of the first type, and removing 1600 the second channel layer 202.

Similarly, the method 1000 may further comprise removing, by selective etching, the sacrificial layers 211, 212, 213, 214, 215, 221, 222, 223, 224 of the first and second types from the second ridge 140, and forming a gate stack on the second ridge 140, the gate stack of the second ridge 140 extending around the first, second, and third channel layers 201, 202, 203 of the second ridge 140, the gate stack of the second ridge 140 comprising a gate dielectric and a gate metal or metals.

Also, although not explicitly shown in Figure 1, the method 1000 may further comprise forming a gate stack on the first ridge 130, the gate stack of the first ridge 130 extending around the first and third channel layers 201, 203 of the first ridge 130 and at least partially extending vertically in a space formed by removing the second channel layer 202 of the first ridge 130, the gate stack of the first ridge 130 comprising a gate dielectric and a gate metal or metals.

Further, it is appreciated that the first sacrificial layer 211 of the first type and the fourth sacrificial layer 224 of the second type may be optional. However, in the Figures, an example of the method 1000 is given wherein the multi-layer stack 200 comprises the first sacrificial layer 211 of the first type and the fourth sacrificial layer 224 of the second type. Hence, it should be understood that the method 1000 may be performed using a multilayer stack 200 which lacks the first sacrificial layer 211 of the first type and/or the fourth sacrificial layer 224 of the second type.

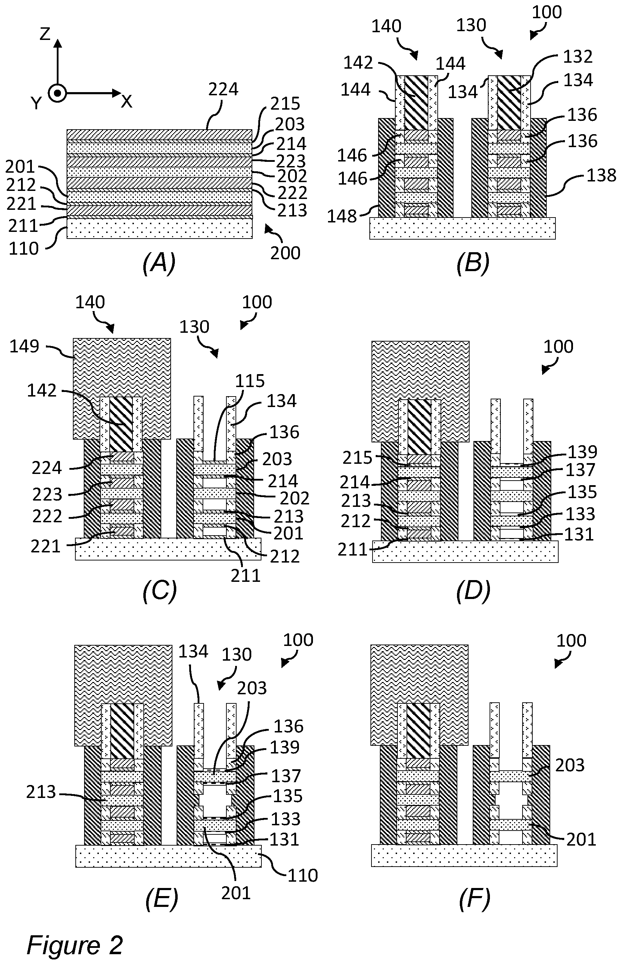

Figures 2A-L illustrate cross-sections of exemplary steps of a method for fabricating a semiconductor structure 100. All of Figures 2A-L show the same cross-sectional plane. In the illustration, the respective ridges extend in the Z-direction.

The figures illustrate cross-sections of the case of devices built on a substrate 110 (e.g., Si substrate). However, the substate 110 may likewise be, e.g., a Silicon-on-insulator (SOI) substrate.

Additionally, for simplicity, the Figures illustrate a scenario where the devices do not include a bottom dielectric isolation layer beneath them, which can be used to achieve better electrical isolation. However, it is to be understood that it is possible to include such a layer. In that case, the multi-layer (epitaxial) stack 200 can either remain as illustrated in the Figures or be simplified by removing the first sacrificial layer 211 of the first type from the multi-layer stack 200.

Figure 2A schematically illustrates a multi-layer stack 200 formed on a substate 110. The multi-layer stack 200 here comprises a first sacrificial layer 211 of a first type on the substrate 110, a first sacrificial layer 221 of a second type on the first sacrificial layer 211 of the first type, a second sacrificial layer 212 of the first type on the first sacrificial layer 221 of the second type, a first channel layer 201 on the second sacrificial layer 212 of the first type, a third sacrificial layer 213 of the first type on the first channel layer 201, a second sacrificial layer 222 of the second type on the third sacrificial layer 213 of the first type, a second channel layer 202 on the second sacrificial layer 222 of the second type, a third sacrificial layer 223 of the second type on the second channel layer 202, a fourth sacrificial layer 214 of the first type on the third sacrificial layer 223 of the second type, a third channel layer 203 on the fourth sacrificial layer 214 of the first type, a fifth sacrificial layer 215 of the first type on the third channel layer 203, and a fourth sacrificial layer 224 of the second type on the fifth sacrificial layer 215 of the first type.

The layers described may be provided by multi-layer epitaxial (epi) growth. Such a process may involve the sequential growth of multiple layers of semiconductor materials to form the multi-layer stack 200.

It is appreciated that the multi-layer stack 200 may comprise additional layers that are not shown in the figure. Such additional layers may be provided depending on the sought final semiconductor structure. The different layers may, for example, be repeated in a specific pattern or layered repetition to, e.g., enable increased number of stacked channels per structure.

In an example, no sacrificial layers of the first type may be provided on or adjacent to channel layers which are to be removed. On the other hand, sacrificial layers of the first type may be specifically provided on or adjacent to channel layers which should be protected from certain processing or fabrication steps.

For the materials of the layers in the multi-layer stack 200, the channel layers 201, 202, 203 may comprise $Si_{1-a}Ge_a$, the sacrificial layers 211, 212, 213, 214, 215 of the first type may comprise $Si_{1-b}Ge_b$, and/or the sacrificial layers 221, 222, 223, 224 of the second type may comprise $Si_{1-c}Ge_c$.

In an example, the values of, a, b, and c may be governed by the following relation: $0 \leq a < b < c$.

In a specific example, $0 \leq a < 0.1$, $0.15 < b < 0.35$, and $0.4 \leq c < 1$. However, it is appreciated that variations may be implemented to suit different device requirements or fabrication steps.

In Figure 2B, the multi-layer stack 200 on the substrate 110 has been processed up to the Replacement Metal Gate (RMG) module. At this stage, the first ridge 130 and the second ridge 140 have been formed from the multi-layer stack 200, e.g., they were patterned into fins that were later recessed in areas for source/drain formation. Each ridge 130, 140 is straddled by a dummy gate 132, 142. Each dummy gate 132, 142 has gate spacers 134, 144 on opposite sides. Further, each ridge 130, 140 comprises inner spacers 136, 146.

The dummy gates 132, 142 are temporary structures that will later be replaced with final metal gate stacks. The gate spacers 134, 144 are insulating materials placed on the sides of the dummy gates to isolate them from the surrounding structures. The inner spacers 136, 146 are additional insulating layers that provide further isolation. Additionally, source/drain (S/D) regions 138, 148 are depicted in the figure. For each ridge there may be two S/D regions, arranged at opposite ends of the ridge. The S/D regions may be epitaxially grown on the opposite ends of the channel layers of the ridge.

Hence, Figure 2B shows a device comprising a first and second ridge 130, 140 arranged on a substrate 110, where each of the first and second ridge 130, 140 comprises part of the multi-layer stack 200.

The ridges 130, 140 are co-integrated on the same substrate 110.

It is appreciated that, a third or fourth ridge, etc. may be formed from the multi-layer stack 200 on the substrate 110.

In addition to the components shown in Figure 2B, the multi-layer stack 200 may include additional layers or variations not depicted in the figure. For instance, there could be additional sacrificial layers, channel layers, or etch stop layers to further refine the fabrication process or improve device performance.

Moreover, variations in the materials and thicknesses, including the thicknesses and materials of the gate spacers 134, 144 and of the inner spacers 136, 146 can be implemented to optimize the electrical characteristics of the device.

In Figure 2C, the dummy gate 132 and the sacrificial layers 221, 222, 223, 224 of the second type of the first ridge 130 have been removed. Hereby, the second channel layer 202 is exposed. The dummy gate may be removed to expose the sides of the multilayer stack of the first ridge. Subsequently, the sacrificial layers 221, 222, 223, 224 of the second type of the first ridge 130 may be removed by selective etching, e.g., selective etching from the exposed sides of the multilayer stack of first ridge.

The selective etching may preferably have high selectivity to the materials of the sacrificial layers 211, 212, 213, 214, 215 of the first type, the channel layers 201, 202, 203, and/or materials of the surrounding components such as the gate spacers 134 and the inner spacers 136.

Further, a protective cap 149 has been added to cover the second ridge 140 and for protecting the second ridge 140 during processing of the first ridge 130. The protective cap 149 may preferably be added to the flow before removing sacrificial layers 221, 222, 223, 224 of the second type of the first ridge 130. Hence, protecting the second ridge 140 from removal of the sacrificial layers 221, 222, 223, 224 of the second type, thereby preserving the components and layers of the second ridge 140.

In other words, by covering the second ridge 140, the cap 149 prevents any potential damage or contamination that could occur from exposure to processing steps such as etching, deposition, or annealing. The protective cap 149 hence allows for sequential processing of the ridges 130, 140.

It is to be understood that the second ridge 140 may be protected by other means than a protective cap 149, which can be made by using various types of materials or/and processes. Alternative protective methods may include the application of protective coatings, the use of temporary sacrificial layers, or other suitable techniques that ensure the integrity of the ridge during the fabrication process.

In the illustrated case, the dummy gate 132, 142, e.g., a dummy gate consisting of an amorphous silicon (aSi) and a dummy gate dielectric, is removed separately for the first and second ridges 130, 140, respectively. Alternatively, the dummy gates 132, 142 may be removed simultaneously from all ridges 130, 140. In such a case, the protective cap 149 would be applied to the second ridge 140 only after the dummy gates 132, 142 have been removed from both ridges 130, 140. The simultaneous removal may be an option to streamline the manufacturing steps and reduce processing time.

In Figure 2D, the sacrificial layers 211, 212, 213, 214, 215 of the first type in the first ridge 130 have been oxidized, thus forming oxidized sacrificial layers 131, 133, 135, 137, 139.

The step of oxidizing the sacrificial layers 211, 212, 213, 214, 215 of the first type may comprise a steam anneal or any suitable anneal. For example, a low thermal budget anneal (e.g., below or at 450 degrees Celsius) may be used to transform the sacrificial layers 211, 212, 213, 214, 215 of the first type into oxide layers 131, 133, 135, 137, 139, e.g., with no significant oxidation of the exposed second channel layer 202.

In Figure 2E, the second channel layer 202 of the first ridge 130 has been removed by etching. The removal may be selective removal/etching of the uncovered second channel layer 202, e.g., with regards to other dielectric layers on the substrate 110 (such as the oxidized sacrificial layers 131, 133, 135, 137, 139, the gate spacers 134 and inner spacers 136, and/or intra layer dielectrics).

In particular, the oxidized sacrificial layers 131, 133, 135, 137, 139 protect the substrate 110 and the first and third channel layers 201, 203 from the etching.

As seen in Figure 2E, the removal of the second channel layer 202 from the first ridge forms a space within the first ridge 130. In other words, by removing the second channel layer 202, a void or space is formed within the confines of the first ridge 130. The created space enables more room for the formation of gate stack layers within the first ridge 130 or the device formed by the first ridge 130.

In Figure 2F, the oxidized sacrificial layers 131, 133, 135, 137, 139 have been removed.

The removal of the oxidized sacrificial layers 131, 133, 135, 137, 139 exposes the first and third channel layers 201, 203. The removal may involve selective etching that targets the oxidized sacrificial layers 131, 133, 135, 137, 139 without significantly affecting surrounding materials.

It is appreciated that (extra) cleaning procedures may be further used to ensure that any residues from the etching process are thoroughly removed.

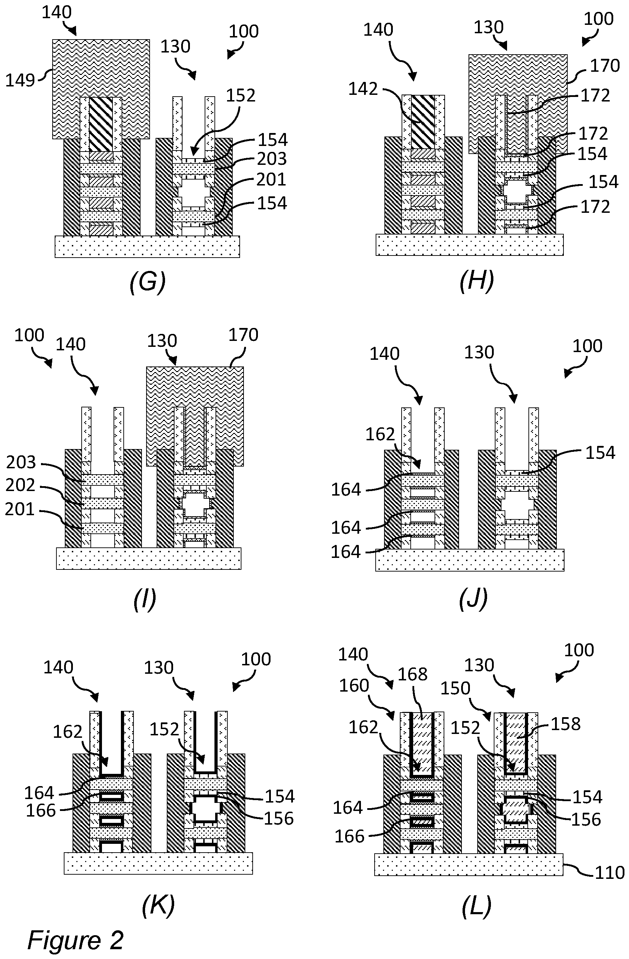

In Figure 2G, a dielectric (such as an oxide) layer 154 has been deposited or grown on the first and third channel layers 201, 203 of the first ridge 130. This step may comprise 'thick-oxide' deposition or growth, e.g., with growth starting from the channel surfaces (e.g., Si channel surfaces in case of Si channels) of the first and third channel layers 201, 203.

Hence, the oxidized sacrificial layers 131, 133, 135, 137, 139 have been replaced by the gate dielectric (such as an oxide) layer 154.

The dielectric (e.g., oxide) layer 154 may be used to form a gate dielectric 152 of the first ridge 130. In other words, the gate dielectric 152 of the first ridge 130 may be formed by replacing the oxidized sacrificial layers 133, 135, 137, 139 around the first and third channel layer 201, 203 by a dielectric (e.g., an oxide) layer 154.

The gate dielectric 152 may serve as an insulating layer (and be either a single or multi-layer, such as it may consist of an oxide layer or layers first grown or deposited followed by the growth of a high-k layer), between a gate electrode and the underlying channel, e.g., preventing direct electrical conduction while allowing the gate to control the channel's conductivity through capacitive coupling.

The thickness of the gate dielectric 154, 152 may influence electrical characteristics of the device formed by the ridge 130, such as its threshold voltage, reliability, and leakage current. A thicker gate dielectric layer 154,152, as used in this context, may be used in devices that need to withstand higher supply voltages.

The process of depositing or growing the dielectric (such as an oxide) layer 152, 154 may involve techniques, such as chemical oxidation or conformal deposition, such as atomic layer deposition (ALD).

In Figure 2H, the protective cap 149 of the second ridge 140 has been removed, e.g., through a selective etching process. The removal exposes the underlying structure of the second ridge 140, allowing for subsequent processing steps.

The protective cap 149 has hereby protected the second ridge 140 at least during the steps of removing the sacrificial layers 221, 222, 223, 224 of the second type from the first ridge 130, oxidizing the sacrificial layers 211, 212, 213, 214, 215 of the first type of the first ridge 130, and removing the second channel layer 202 from the first ridge 130.

Further, in Figure 2H, a protective cap 170 has been added (e.g., its material(s) coated, deposited, or grown followed by patterning) on the first ridge 130. For example, the protective cap 170 may be added by using a spin-on-carbon (SOC) material, resist or/and dielectric by coating them or using a chemical vapor deposition (CVD), ALD, PDV process, followed by its patterning for selective protection.

The protective cap 170 of the first ridge 130 may protect or cover the first ridge 130 during fabrication steps for the second ridge 140.

In addition, a protective layer 172 for the first ridge 130 can also be deposited, as illustrated in Figure 2H. The protective layer 172 may serve to shield the first ridge 130 from being damaged or contaminated during the adding of the protective cap 170 and/or other subsequent fabrication steps. Alternatively, or in conjunction, a high-k gate dielectric layer could be deposited here. For example, the protective layer 172 may be a high-k dielectric layer.

The high-k gate dielectric layer may also be grown or deposited earlier or later in the flow (see high-k gate dielectric layer 156 in Figure 2K), e.g., it can be implemented simultaneously for both the first 130 and second 140 ridges. This may be advantageous if the high-k material is the same or similar for both ridges 130, 140.

Furthermore, although not shown in the figure, plasma exposure, such as fluorine-based (F-based) plasma may be introduced, e.g., to enhance the properties (e.g., electrical properties) of the dielectric layers. Plasma treatment may modify the dielectric layer(s) characteristics and improve its properties. The use of plasma exposure such as F-based plasma exposure may assist in reducing defects or/and overall enhancing quality of the dielectric layers, i.e., the dielectric (such as an oxide) 154 and/or the high-k dielectric layer (e.g., represented by the protective layer 172, or by the high-k dielectric layer 156 in Fig. 2L when it is inserted later in the flow and simultaneously for the two ridges 130, 140).

In Figure 2I, the dummy gate 142 of the second ridge 140 has been removed.

Notably, in the schematic figures shown here, the dummy gate 142 of the second ridge 140 is first covered by the protective cap 149 and only removed after the thicker-gate dielectric (e.g., oxide) 154 formation. However, alternative process flows may be employed where the dummy gate 142 is removed at different stages. For instance, the dummy gate 142 may be removed earlier in the process, or simultaneously with other steps.

Further, the sacrificial layers 211, 212, 213, 214, 215, 221, 222, 223, 224 of the first and second types of the second ridge 140 have been removed.

To avoid undue repetition, it is appreciated that the dummy gate 142 and sacrificial layers 211, 212, 213, 214, 215, 221, 222, 223, 224 of the second ridge 140 may, respectively, be removed by similar processes such as the corresponding components and layers of the first ridge 130, i.e., one or more etching processes such as selective etching, e.g., with high selectivity to a material of the channel layers 201, 202, 203.

Further, as illustrated in the figure, the protective cap 170 is protecting the first ridge 130 during the step of removing the sacrificial layers 211, 212, 213, 214, 215, 221, 222, 223, 224 of the first and second types from the second ridge 140. However, it is to be understood that the ridge 130 may be protected by other means than a protective cap 170. Alternative protective methods may include, but are not limited to, the application of protective coatings, the use of temporary sacrificial layers, or other suitable protective techniques that ensure the integrity of the ridge during the fabrication process.

In Figure 2J, the protective cap 170 has been removed from the first ridge 130. Further, the protective layers 172 have been removed. The removal of the protective cap 170 and protective layers 172 may, e.g., be removed by one or more etching process (e.g., selective etching processes). It is appreciated that in a case where the protective layer 172 is a high-k dielectric layer, the protective layer 172 may not necessarily be removed.

Figure 2J also illustrates the addition of a dielectric (e.g., oxide) 164 on the channel layers 201, 202, 203 of the second ridge 140. Hence, similar to as discussed in relation to Figure 1G, the dielectric (e.g., oxide) 164 may be used to form a gate dielectric 162 of the second ridge 140.

The dielectric (e.g., oxide) 164 may be deposited or grown on the channel layers 201, 202, 203 of the second ridge 140, e.g., similar to the growth/deposition of the dielectric (e.g., oxide) 154 of the first ridge 130. The oxide 164 may, e.g., be grown or deposited before or after the removal of the protective cap 170 and/or the protective layer 172.

The dielectric (e.g., oxide) 164 of the second ridge 140 may be thinner than the dielectric (e.g., oxide) 154 on the first ridge 130. In other words, the dielectric (e.g., oxide) 154 of the first ridge 130 may be a thicker-dielectric (e.g., oxide) layer and the dielectric (e.g., oxide) 164 of the second ridge 140 may be a thinner-dielectric (e.g., oxide) layer, relatively.

Hence, the first ridge 130 and the second ridge 140 may correspond to different types of devices within the semiconductor structure 100. For example, the first ridge 130 may be part of an I/O device, which typically requires a thicker dielectric (e.g., oxide) layer 154 to be able to withstand higher supply voltages. On the other hand, the second ridge 140 may be part of a logic device, which may benefit from a thinner dielectric (e.g., oxide) layer 164, e.g., to achieve higher drivability, faster switching speeds and overall higher performance.

In Figure 2K, high-k dielectric layers 156, 166 have been formed on the ridges 130 and 140. The high-k dielectric layers 156, 166 may be used to reduce the effective gate dielectric thickness (EOT) and to reduce the gate leakage current.

Thus, forming of the gate dielectrics 152, 162 of the first and second ridge 130, 140, may comprise forming a respective high-k dielectric layer 156, 166. Hence, the respective gate dielectric 152, 162 may comprise adielectric (e.g., oxide) layer 154, 164 and a high-k gate dielectric layer 156, 166.

The high-k dielectric layers 156, 166 may comprise a high-k dielectric material (i.e., a material with a high dielectric constant). Some examples of high-k materials typically being used are hafnium oxide ($HfO_2$), or zirconium oxide ($ZrO_2$), or hafnium zirconium oxide (HZO).

The deposition or growth of the high-k dielectric layers 156, 166 may, for example, be achieved through techniques such as ALD.

In the schematic figures illustrated here, the gate dielectric (e.g., oxide) layer 154 and 164 and the high-k dielectric layer 156, 166 are formed in a simplistic manner and represented by single layers in the figures, however, it is to be understood different gate dielectrics namely dipole-based gate dielectrics may and can be used for effective work function (EWF) tuning in devices with different threshold voltage targets. This means that by selecting appropriate materials and deposition conditions, the electrical properties of the gate dielectrics 152, 162 can be tailored to meet the specific needs of various devices. For instance, devices requiring different threshold voltage targets can benefit from customized gate dielectric 154, 164 (e.g., oxides with or without including specific dipole layer(s) and with possible varying composition/structure through their layer thicknesses) and high-k dielectric layers 156, 166 to optimize their performance.

In Figure 2L, a metal or metals 158, 168 has been formed in the first and second ridge 130, 140.

Hence, a respective gate stack 150, 160 has been formed on the first and second ridge 130, 140. The respective gate stack 150, 160 of the first ridge 130 and the second ridge 140, respectively, comprises a gate dielectric 152, 162 and a gate metal or metals 158, 168.

The gate stack 150 of the first ridge 130 extends around the first and third channel layers 201, 203 of the first ridge 130 and (at least partially) extending in a space formed by the removal of the second channel layer 202 of the first ridge 130 (as discussed in relation to Figure 2E). On the other hand, the gate stack 160 of the second ridge 140 extends around the first, second, and third channel layers 201, 202, 203 of the second ridge 140.

As seen in Figure 2L, the gate dielectric 152 of the gate stack 150 of the first ridge 130 is thicker than the gate dielectric 162 of the gate stack 160 of the second ridge 140. The first ridge 130, which may correspond to an I/O device, typically comprise a thicker gate dielectric 152. The thicker layer helps/is required to withstand higher supply voltages. On the other hand, the second ridge 140, which may correspond to a logic device, is designed with a thinner gate dielectric 162. The thinner thickness of the gate dielectric 162 is required to meet the performance requirements of scaled logic devices.

The steps of forming the metals 158, 168 may comprise depositing effective work function (EWF) metals, followed by metal-fill and/or planarization, e.g., by using chemical mechanical polishing (CMP). The EWF metals may be selected based on their ability to achieve the desired work function values, e.g., for helping set the required threshold voltage values of the devices.

The deposition of EWF metals may comprise choosing materials that provide an appropriate or desired work function. For instance, metals such as titanium nitride (TiN), tantalum nitride (TaN), Al-based metals/alloys may be employed.

After the EWF metals are deposited, remaining space may be filled with a metal such as tungsten, to form the complete gate stack 150, 160. The filled metal may be planarized, e.g., by using CMP, to achieve a smooth and uniform surface, and to selectively remove the metal(s) from the other parts of the wafer covered by dielectrics, i.e., from non-gate areas.

While the simplified version illustrated here shows a uniform approach, it is appreciated that different EWF metals may be used for PMOS and NMOS devices, and potentially different materials with varying thicknesses, namely different dipole materials and EWF metals, may also be employed for devices with varying voltage threshold targets.

The schematic figures illustrate certain steps in the fabrication process of the semiconductor structure 100, however, it is to be understood that additional processing steps, although not shown, may be applied to further refine and complete the semiconductor structure 100 and/or the devices formed by the ridges 130, 140. Such additional steps may include, but are not limited to, processes beyond the Replacement Metal Gate (RMG) module. For instance, subsequent steps could involve the formation of contacts, interconnects, and/or annealing processes (e.g., to improve material properties or device performance).

As seen throughout figures 2A-L, the first ridge 130 and the second ridge 140 form respective devices co-integrated on the substrate 110.

In the above the inventive concept has mainly been described with reference to a limited number of examples. However, as is readily appreciated by a person skilled in the art, other examples than the ones disclosed above are equally possible within the scope of the inventive concept, as defined by the appended claims.

**Claims**

1. A method (1000) for fabricating a semiconductor structure (100), the method comprising:

   providing (1100) a substrate (110);

providing (1200), on top of the substrate (110), a multi-layer stack (200) comprising:

a bottom sacrificial layer comprising: a first sacrificial layer (211) of a first type on the substrate (110) and a first sacrificial layer (221) of a second type on the first sacrificial layer (211) of the first type; or a first sacrificial layer (221) of a second type on the substrate (110), a second sacrificial layer (212) of the first type on the bottom sacrificial layer, a first channel layer (201) on the second sacrificial layer (212) of the first type, a third sacrificial layer (213) of the first type on the first channel layer (201), a second sacrificial layer (222) of the second type on the third sacrificial layer (213) of the first type, a second channel layer (202) on the second sacrificial layer (222) of the second type, a third sacrificial layer (223) of the second type on the second channel layer (202), a fourth sacrificial layer (214) of the first type on the third sacrificial layer (223) of the second type, a third channel layer (203) on the fourth sacrificial layer (214) of the first type, and a fifth sacrificial layer (215) of the first type on the third channel layer (203);

forming (1300) a first and second ridge (130,140) from the multi-layer stack (200); and for the first ridge (130):

removing (1400) the sacrificial layers (221, 222, 223) of the second type by selective etching, oxidizing (1500) the sacrificial layers (211, 212, 213, 214, 215) of the first type, and removing (1600) the second channel layer (202) by selective etching, wherein the oxidized sacrificial layers (131, 133, 135, 137, 139) protect the substrate (110) and the first and third channel layers (201, 203) from the selective etching step used to remove the second channel layer (202).

2. The method (1000) according to claim 1, wherein the method (1000) further comprises: protecting the second ridge (140) during the steps of, for the first ridge (130):

removing (1400) the sacrificial layers (221, 222, 223) of the second type, oxidizing (1500) the sacrificial layers (211, 212, 213, 214, 215) of the first type, and

removing (1600) the second channel layer (202).

3. The method (1000) according to claim 2, wherein the method (1000) further comprises:

removing, by selective etching, the sacrificial layers (211, 212, 213, 214, 215, 221, 222, 223) of the first and second types from the second ridge (140), and forming a gate stack (160) on the second ridge (140), the gate stack (160) of the second ridge (140) extending around the first, second, and third channel layers (201, 202, 203) of the second ridge (140), the gate stack (160) of the second ridge (140) comprising a gate dielectric (162) and a gate metal (168).

4. The method (1000) according to claim 3, wherein the first ridge (130) is protected during the step of removing the sacrificial layers (211, 212, 213, 214, 215, 221, 222, 223) of the first and second types from the second ridge (140).

5. The method (1000) according to any one of the preceding claims, wherein the first ridge (130) and the second ridge (140) form respective devices co-integrated on the substrate (110).

6. The method (1000) according to any one of the preceding claims, wherein the method (1000) further comprises: forming a gate stack (150) on the first ridge (130), the gate stack (150) of the first ridge (130) extending around the first and third channel layers (201, 203) of the first ridge (130) and at least partially extending in a space formed by removing the second channel layer (202) of the first ridge (130), the gate stack (150) of the first ridge (130) comprising a gate dielectric (152) and a gate metal (158).

7. The method (1000) according to claim 6, when dependent on claim 3, wherein the gate dielectric (152) of the gate stack (150) of the first ridge (130) is thicker than the gate dielectric (162) of the gate stack (160) of the second ridge (140).

8. The method (1000) according to any one of claims 6-7, wherein forming the gate dielectric (152) of the gate stack (150) of the first ridge (130) comprises: replacing the oxidized sacrificial layers (131, 133, 135, 137, 139) by a dielectric such as an oxide layer (154).

9. The method (1000) according to any one of the preceding claims, wherein the channel layers (201, 202, 203) comprises $Si_{1-a}Ge_a$, the sacrificial layers (211, 212, 213, 214, 215) of the first type comprises $Si_{1-b}Ge_b$, and/or the sacrificial layers (221, 222, 223) of the second type comprises $Si_{1-c}Ge_c$, wherein $0 \leq a < b < c$.

10. The method (1000) according to claim 9, wherein

$$0 \leq a < 0.1;$$

$$0.15 < b < 0.35;$$

and

$$0.4 \leq c < 1.$$

11. The method (1000) according to any one of the preceding claims, wherein a temperature during the step of oxidizing (1500) is below or at 450 degrees Celsius.

12. The method (1000) according to any one of the preceding claims, wherein the step of oxidizing (1500) comprises a steam anneal.

13. A device comprising a first and second ridge (130,140) arranged on a substrate (110), each of the first and second ridge (130,140) comprising a multi-layer stack (200) comprising:

a bottom sacrificial layer comprising:
a first sacrificial layer (211) of a first type on the substrate (110) and a first sacrificial layer (221) of a second type on the first sacrificial layer (211) of the first type; or a first sacrificial layer (221) of a second type on the substrate (110),
a second sacrificial layer (212) of the first type on the bottom sacrificial layer,
a first channel layer (201) on the second sacrificial layer (212) of the first type,
a third sacrificial layer (213) of the first type on the first channel layer (201),
a second sacrificial layer (222) of the second type on the third sacrificial layer (213) of the first type,
a second channel layer (202) on the second sacrificial layer (222) of the second type,
a third sacrificial layer (223) of the second type on the second channel layer (202),
a fourth sacrificial layer (214) of the first type on the third sacrificial layer (223) of the second type,
a third channel layer (203) on the fourth sacrificial layer (214) of the first type, and
a fifth sacrificial layer (215) of the first type on the third channel layer (203),
wherein the channel layers (201, 202, 203) comprises $Si_{1-a}Ge_a$, the sacrificial layers (211, 212, 213, 214, 215) of the first type comprises $Si_{1-b}Ge_b$, and the sacrificial layers (221, 222, 223) of the second type comprises $Si_{1-c}Ge_c$, and wherein $0 \leq a < b < c$.

14. The device according to claim 13, wherein

$$0 \leq a < 0.1,$$

$$0.15 < b < 0.35;$$

and

$$0.4 \leq c < 1.$$

1000

```
┌─────────────────────────────────────────────────────┐
│              Providing a substrate                   │──── 1100
└─────────────────────────────────────────────────────┘
                          │
                          ▼
┌─────────────────────────────────────────────────────┐
│     Providing, on top of the substrate, a multilayer stack
│                     comprising:
│     a first sacrificial layer of a first type on the substrate,
│     a first sacrificial layer of a second type on the first sacrificial
│                  layer of the first type,
│     a second sacrificial layer of the first type on the first sacrificial
│                  layer of the second type,
│     a first channel layer on the second sacrificial layer of the first
│                           type,
│     a third sacrificial layer of the first type on the first channel layer,
│        a second sacrificial layer of the second type on the third
│                  sacrificial layer of the first type,
│        a second channel layer on the second sacrificial layer of the     │──── 1200
│                       second type,
│        a third sacrificial layer of the second type on the second
│                       channel layer,
│     a fourth sacrificial layer of the first type on the third sacrificial
│                  layer of the second type,
│     a third channel layer on the fourth sacrificial layer of the first
│                           type,
│     a fifth sacrificial layer of the first type on the third channel layer,
│                           and
│        a fourth sacrificial layer of the second type on the fifth
│                  sacrificial layer of the first type,
└─────────────────────────────────────────────────────┘
                          │
                          ▼
┌─────────────────────────────────────────────────────┐
│    Forming a first and second ridge from the multilayer stack   │──── 1300
└─────────────────────────────────────────────────────┘
                          │
                          ▼
┌─────────────────────────────────────────────────────┐
│   Removing, for the first ridge, the sacrificial layers of the second
│                  type by selective etching                       │──── 1400
└─────────────────────────────────────────────────────┘
                          │
                          ▼
┌─────────────────────────────────────────────────────┐
│  Oxidizing, for the first ridge, the sacrificial layers of the first type │──── 1500
└─────────────────────────────────────────────────────┘
                          │
                          ▼
┌─────────────────────────────────────────────────────┐
│   Removing, for the first ridge, the second channel layer by
│                  selective etching                               │──── 1600
└─────────────────────────────────────────────────────┘
```

*Figure 1*

*Figure 2*

*Figure 2*

Europäisches
Patentamt
European
Patent Office
Office européen
des brevets

# EUROPEAN SEARCH REPORT

**Application Number**

EP 24 21 5646

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/231020 A1 (FROUGIER JULIEN [US] ET AL) 21 July 2022 (2022-07-21) | 13,14 | INV.<br>H10D84/01 |
| A | * figures 2-10, 13-15 and correlated description * | 1,2 | H10D30/01<br>H10D64/27 |
| | ----- | | H10D84/03 |
| A | US 2017/104060 A1 (BALAKRISHNAN KARTHIK [US] ET AL) 13 April 2017 (2017-04-13)<br>* figures 2-18 and correlated description * | 1-14 | H10D84/83 |
| | ----- | | |
| A | US 10 141 403 B1 (CHENG KANGGUO [US] ET AL) 27 November 2018 (2018-11-27)<br>* figures 1-11 and correlated description * | 1-10 | |
| | ----- | | |

**TECHNICAL FIELDS SEARCHED (IPC)**

H10D

The present search report has been drawn up for all claims

| Place of search | Date of completion of the search | Examiner |
|---|---|---|
| Munich | 13 May 2025 | Corchia, Alessandra |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.............................................................................................
& : member of the same patent family, corresponding
    document

EPO FORM 1503 03.82 (P04C01)

2

## ANNEX TO THE EUROPEAN SEARCH REPORT
## ON EUROPEAN PATENT APPLICATION NO.

EP 24 21 5646

13-05-2025

| Patent document cited in search report | Publication date | Patent family member(s) | Publication date |
|---|---|---|---|
| US 2022231020 A1 | 21-07-2022 | NONE | |
| US 2017104060 A1 | 13-04-2017 | US 2017104060 A1<br>US 2017194143 A1 | 13-04-2017<br>06-07-2017 |
| US 10141403 B1 | 27-11-2018 | NONE | |

EPO FORM P0459

For more details about this annex : see Official Journal of the European Patent Office, No. 12/82